(19) **Europäisches Patentamt European Patent Office Office européen des brevets**

(11) **EP 3 771 917 B1**

(12) **FASCICULE DE BREVET EUROPEEN**

(45) Date de publication et mention de la délivrance du brevet:
**20.04.2022 Bulletin 2022/16**

(21) Numéro de dépôt: **20183221.9**

(22) Date de dépôt: **30.06.2020**

(51) Classification Internationale des Brevets (IPC):
***G01R 33/26*** *(2006.01)*

(52) Classification Coopérative des Brevets (CPC):
**G01R 33/26**

(54) **MAGNÉTOMÈTRE À POMPAGE OPTIQUE**

OPTISCH GEPUMPTES MAGNETOMETER

MAGNETOMETER WITH OPTICAL PUMPING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.07.2019 FR 1908624**

(43) Date de publication de la demande:
**03.02.2021 Bulletin 2021/05**

(73) Titulaire: **Commissariat à l'énergie atomique et aux énergies alternatives 75015 Paris (FR)**

(72) Inventeurs:
• **GARCES MALONDA, Rafael**
  **38054 GRENOBLE Cedex 09 (FR)**
• **PALACIOS LALOY, Agustin**
  **38054 GRENOBLE Cedex 09 (FR)**
• **GIDON, Serge**
  **38054 GRENOBLE Cedex 09 (FR)**

(74) Mandataire: **Brevalex 95, rue d'Amsterdam 75378 Paris Cedex 8 (FR)**

(56) Documents cités:
**JP-A- 2009 236 599    US-A1- 2015 115 948 US-B1- 7 826 065**

• **HERBERT CREPAZ ET AL: "Cavity enhanced atomic magnetometry", SCIENTIFIC REPORTS, vol. 5, no. 1, 20 octobre 2015 (2015-10-20), XP055681060, DOI: 10.1038/srep15448**
• **S. LI ET AL: "Optical rotation in excess of 100 rad generated by Rb vapor in a multipass cell", PHYSICAL REVIEW A, vol. 84, no. 6, 6 décembre 2011 (2011-12-06), XP055165970, ISSN: 1050-2947, DOI: 10.1103/PhysRevA.84.061403**

**Description**

## DOMAINE TECHNIQUE

Le domaine de l'invention est celui des magnétomètres à pompage optique, et plus particulièrement celui des magnétomètres à pompage optique basés sur des effets linéaires (effet Hanle, résonance magnétique, ou résonance paramétrique). L'invention trouve application pour l'imagerie des champs biomagnétiques au moyen d'un réseau de magnétomètres, notamment en magnétocardiographie ou en magnétoencéphalographie.

## TECHNIQUE ANTÉRIEURE

Les magnétomètres à pompage optique utilisent un gaz atomique confiné dans une cellule, typiquement de l'hélium métastable ou des gaz d'alcalins, en tant qu'élément sensible. Ces magnétomètres, qui peuvent prendre différentes configurations, permettent de remonter au champ magnétique en exploitant les trois processus suivants qui ont lieu de façon soit séquentielle soit concomitante :

1) L'utilisation de sources de lumière polarisée, typiquement des lasers, permet de préparer des états atomiques caractérisés par une certaine orientation ou alignement de leurs spins. Ce processus reçoit le nom de « pompage optique » dans le domaine.

2) Ces états atomiques évoluent sous l'effet du champ magnétique, notamment sous l'effet Zeeman qui correspond à des décalages des niveaux d'énergie en fonction du champ magnétique auquel sont soumis les atomes.

3) Les propriétés optiques du milieu atomique subissent alors des modifications qui dépendent de l'état des atomes. On peut ainsi par une mesure optique, par exemple par une mesure d'absorption optique, remonter au décalage Zeeman subi et en déduire une mesure du champ magnétique dans lequel est plongée la cellule.

On distingue deux grandes catégories de magnétomètres à pompage optique selon le type de pompage réalisé.

Dans la catégorie la plus répandue, le pompage est réalisé avec un faisceau de pompage émettant une lumière à polarisation circulaire et le gaz atomique acquiert un état dit orienté caractérisé par une valeur moyenne non nulle de son moment magnétique selon un axe, qui se trouve être celui de propagation du faisceau de pompage.

Dans l'autre catégorie, le pompage est réalisé avec un faisceau de pompage émettant une lumière en polarisation linéaire et le gaz atomique acquiert un état dit aligné caractérisé par une valeur nulle de son moment magnétique, mais par une valeur non nulle d'une grandeur du type $(3 F_z^2 - F^2)$ où F est le moment cinétique total et Fz le moment cinétique le long de la direction de polarisation du faisceau de pompage.

La caractérisation des états atomiques (étape 3 ci-dessus) peut être réalisée selon au moins deux schémas :

- en mesurant l'absorption d'un faisceau accordé (ou très proche) à la transition atomique considérée (le faisceau utilisé pour le pompage ou un faisceau dit « sonde » de même polarisation que le faisceau utilisé pour le pompage) ;
- en utilisant un faisceau dit « sonde » de polarisation linéaire et décalé en longueur d'onde par rapport à la transition atomique considérée. Selon le type de polarisation atomique (orientation ou alignement), ce faisceau subit une modification de sa polarisation (rotation du plan de polarisation dans le cas de l'orientation, création d'une composante polarisée circulairement dans le cas de l'alignement) qui peut être mesurée en séparant deux des états de polarisation du faisceau (les deux polarisations à 45° dans le cas de l'orientation, les deux polarisations circulaires dans le cas de l'alignement) puis en les photo-détectant de manière à identifier l'accroissement d'une des polarisations par rapport à l'autre. On parle alors de mesure polarimétrique.

Dans les deux schémas, il est fréquent que la limite de bruit du magnétomètre provienne du bruit de photons (aussi dénommé *shot-noise* dans la littérature anglo-saxonne) qui résulte de la nature discrète des photons qui sont photo-détectés et est caractérisé par un spectre plat et une densité spectrale qui augmente avec la racine carrée de l'intensité de la lumière. Afin d'augmenter le rapport signal-à-bruit, il est nécessaire d'augmenter le signal sans trop augmenter l'intensité de la sonde car cela risque d'entraîner un élargissement de la résonance atomique et une dégradation de la sensibilité au champ magnétique.

Pour améliorer le niveau de rapport signal-à-bruit, il apparait donc souhaitable d'augmenter l'impact que les propriétés atomiques ont sur les variations des signaux lumineux qui sont photo-détectés après leur passage dans la cellule.

Une possibilité pour cela est d'allonger le chemin optique parcouru par la lumière dans la cellule contenant le gaz atomique. Cependant, étant donné que dans des nombreuses applications la taille du capteur doit être réduite, il est nécessaire d'obtenir ce gain de signal par une autre méthode. Une autre solution consiste à faire en sorte que la lumière interagisse plusieurs fois avec le milieu atomique avant d'être détectée. Deux stratégies différentes ont été proposées dans cet objectif, l'utilisation de cavités à passages multiples non résonantes et l'utilisation de résonateurs optiques.

Des travaux réalisés à l'Université de Princeton sur des magnétomètres basés sur l'orientation atomique et divulgués notamment dans l'article « Optical rotation in excess of 100 rad generated by Rb vapor in a multipass cell » de S. Li et al., Phys. Rev. A 84, 061403 (2011) ont ainsi démontré la possibilité d'améliorer le niveau de signal-à-bruit au moyen d'une cavité multi-passage dans laquelle la lumière d'un faisceau de sonde parcourt plusieurs fois le milieu atomique. Cette cavité est une cavité délimitée par deux miroirs paraboliques désaxés, dont l'un présente une ouverture transparente de petite taille en son centre. Un faisceau lumineux légèrement divergent est envoyé par ce trou. Ce faisceau subit une expansion progressive dans la cavité, atteint une taille maximale puis reconverge jusqu'à ressortir par le même trou. Si cette architecture permet de réaliser un nombre important de passages et d'atteindre un gain très significatif de signal-à-bruit, l'agencement des miroirs est assez complexe à réaliser. Par ailleurs, comme le faisceau subit une expansion progressive, la première trajectoire de propagation est tellement étroite que les atomes se trouvant dans le volume de celle-ci contribuent de façon beaucoup plus marquée au signal que tous les autres. Des niveaux de bruit nettement moins bons que ceux escomptés sont ainsi obtenus.

Comme rapporté dans l'article de H.Crepaz, Li Yuan Ley et R. Dumke, « Cavity enhanced atomic magnetometry », Sci. Rep. 5, 15448 (2015), l'utilisation d'un résonateur optique a été expérimentée dans un magnétomètre réalisant une mesure de rotation magnéto-optique non linéaire avec une lumière de sonde modulée en amplitude (AM-NMOR pour « Amplitude Modulated-Nonlinear magneto-Optical Rotation »), mesure pour laquelle la rotation de la polarisation dépend de l'intensité de la lumière de sonde. Ce magnétomètre à cavité résonante consiste en une cellule sphérique remplie d'atomes de césium agencée entre deux miroirs plan-concaves semi-transparents. L'utilisation d'une cavité présentant une finesse optique de 12,7 permet d'améliorer le rapport signal sur bruit d'un facteur 17. Ce résultat contraste avec les prévisions théoriques, qui montrent une augmentation attendue de l'ordre de la finesse de la cavité.

Le brevet US 5,982,174 décrit un milieu optique présentant un effet biréfringent non réciproque, en l'occurrence une fibre optique, placé dans une cavité Fabry-Pérot de manière à maximiser cet effet. L'effet utilisé est intrinsèque au milieu optique mis en oeuvre, et d'une grandeur très faible par rapport à celui qui peut être obtenu lorsque l'état de ce milieu peut être préparé par un procédé tel que le pompage optique, ce qui devient possible dans le cas d'un gaz atomique. Ce type de procédé de pompage optique requiert un faisceau lumineux de pompe, accordé à la transition atomique, dont le but est de préparer l'état du gaz atomique de manière à maximiser la dépendance de ses propriétés de birefringence par rapport aux variations du champ magnétique ambiant. Lorsqu'un seul faisceau est utilisé à la fois pour réaliser la pompe et la sonde, ce qui correspond au schéma du brevet US 5,982,174 il n'est pas possible d'obtenir un gain satisfaisant de signal par l'adjonction d'une cavité Fabry-Pérot. En effet lorsque l'absorption du faisceau de sonde n'est pas prise en considération, un modèle mathématique simple montre que le rapport signal à bruit est proportionnel à la finesse de la cavité optique, soit à $\frac{1+R}{1-R}$ où R est la réflectivité des miroirs qui délimitent la cavité.

En réalité, une absorption même résiduelle engendre une perte de signal. Or lorsqu'un seul faisceau est utilisé pour réaliser les deux fonctions (pompe et sonde) :

- soit le faisceau est résonant avec une transition atomique, ce qui permet de préparer l'état du gaz atomique, mais entraine une absorption importante du faisceau optique à chaque passage qui réduit très significativement le gain en signal à bruit obtenu par l'adjonction de la cavité Fabry-Pérot ;
- soit ce faisceau est suffisamment décalé par rapport à la transition atomique pour ne pas avoir cet effet indésirable, mais alors le gaz atomique est trop faiblement pompé ce qui réduit très significativement la sensibilité de ses propriétés de birefringence au champ magnétique ambiant.

Lorsqu'un seul faisceau est utilisé à la fois comme pompe et sonde, le gain en termes de rapport signal-à-bruit reste donc dans tous les cas très limité.

## EXPOSÉ DE L'INVENTION

L'invention a pour objectif de proposer un magnétomètre à pompage optique basé sur des effets linéaires (effet Hanle, résonance magnétique, ou résonance paramétrique) et dont le rapport signal à bruit est augmenté. Pour atteindre cet objectif, l'invention propose un magnétomètre à pompage optique comprenant une cellule optiquement résonante remplie d'un gaz atomique, ladite cellule présentant une fréquence de résonance, et une source optique. La source optique est configurée pour éclairer ladite cellule avec une lumière de pompage sous l'effet de laquelle les atomes du gaz atomique subissent une transition atomique et une lumière de sonde qui subit des variations de polarisation lors de la traversée de la cellule. La lumière de pompage présente une première fréquence non accordée à la fréquence de résonance. La lumière de sonde présente une fréquence accordée à la fréquence de résonance et passe une pluralité de fois à travers ladite cellule. Un détecter vient réaliser une mesure polarimétrique de la lumière de sonde ayant traversée la cellule.

Certains aspects préférés mais non limitatifs de ce magnétomètre sont les suivants :

- ladite cellule comprend des miroirs agencés face-à-face et un conteneur du gaz atomique entre les miroirs ;
- il comprend en outre un système d'accord pour accorder la fréquence de résonance à la fréquence de la lumière de sonde ;
- le système d'accord comprend un dispositif de chauffage de ladite cellule ;
- le dispositif de chauffage comprend un absorbeur de chaleur placé sur la cellule et une source de chaleur configurée pour irradier l'absorbeur de chaleur ;
- le système d'accord comprend en outre un thermomètre couplé à ladite cellule pour en mesurer la température et un contrôleur configuré pour contrôler le dispositif de chauffage à partir de la température mesurée ;
- la lumière de pompage est accordée en longueur d'onde au centre d'une raie atomique et la lumière de sonde est accordée en longueur d'onde de manière à être décalée du centre de ladite raie atomique.
- le détecteur comprend un analyseur de polarisation configuré pour réaliser une mesure de la polarisation circulaire droite et de la polarisation circulaire gauche de la lumière de sonde ayant traversée la cellule ;
- l'analyseur de polarisation est configuré pour réaliser une mesure différentielle desdites polarisations droite et gauche ;
- il comprend en outre un circuit d'excitation de résonances paramétriques configuré de manière à induire dans la cellule une modulation de champ radiofréquence ;
- la lumière de pompage est polarisée linéairement.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1 est un schéma d'un magnétomètre selon l'invention ;
la figure 2 est un schéma d'une cellule optiquement résonante pouvant être utilisée dans un magnétomètre selon l'invention ;
la figure 3 est un schéma de moyens pouvant être mis en oeuvre pour ajuster la fréquence de résonance de la cellule optiquement résonante.

## DESCRIPTION DÉTAILLÉE

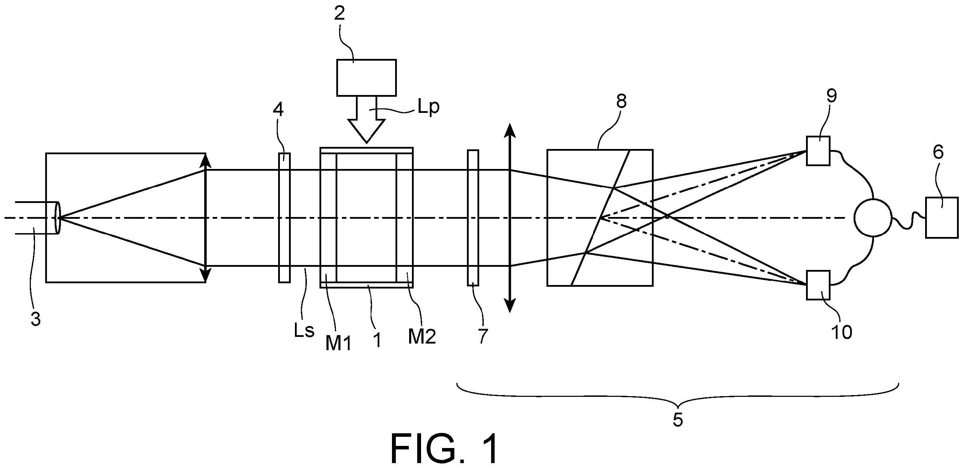

En référence à la figure 1, l'invention porte sur un magnétomètre à pompage optique qui comprend une cellule 1 remplie d'un gaz atomique, par exemple de l'hélium-4 ou un gaz alcalin, et qui est soumis à un champ magnétique ambiant $B_0$. Dans le cadre de l'invention, la cellule est optiquement résonante (elle forme un résonateur de Fabry-Pérot) et présente une fréquence de résonance. Comme cela sera détaillé par la suite, la cellule peut comprendre des miroirs M1, M2 agencés face-à-face et un conteneur du gaz atomique entre les miroirs.

Dans le cas où l'élément sensible est l'hélium-4, le magnétomètre 10 comporte par ailleurs un système d'application, au moyen de deux électrodes couplées à la cellule, d'une décharge haute fréquence pour amener les atomes du gaz atomique dans un état énergisé où ils sont aptes à subir une transition atomique, typiquement dans l'état métastable $2^3S_1$.

Le magnétomètre comprend une source optique configurée pour éclairer ladite cellule 1 avec à la fois une lumière de pompage Lp sous l'effet de laquelle les atomes du gaz atomique subissent une transition atomique et une lumière de sonde Ls qui va subir des variations de polarisation (ainsi qu'éventuellement des absorptions) lors de la traversée de la cellule. Cette source optique peut comprendre une première unité 2 configurée pour éclairer ladite cellule 1 avec la lumière de pompage Lp et une deuxième unité 3 configurée pour éclairer ladite cellule 1 avec la lumière de sonde Ls.

La lumière de pompage Lp présente une première fréquence non accordée à la fréquence de résonance de la cavité optiquement résonante. Pour que les atomes du gaz atomique subissent la transition atomique, la lumière de pompage peut être accordée en longueur d'onde au centre d'une raie de transition atomique, par exemple sur la raie $D_0$ à 1083 nm dans le cas de l'hélium-4.

La lumière de pompage peut être émise par une source laser et être polarisée au moyen d'un polariseur intercalé entre la source laser et la cellule ou directement intégré à la source laser 2.

Dans un mode de réalisation préférentiel, la lumière de pompage est polarisée linéairement. Comme décrit dans l'article de F. Beato et al. intitulé « Theory of a 4He parametric-resonance magnetometer based on atomic alignment », Physical Review A 98, 053431 (2018), les magnétomètres réalisant un pompage en polarisation linéaire présentent des avantages significatifs par rapport aux magnétomètres réalisant un pompage en polarisation circulaire. Ces avantages sont notamment une meilleure résolution sur certains axes de mesure et une sensibilité moindre à des phénomènes indésirables, notamment le phénomène connu comme « light-shift » ou « AC-Stark shift » selon lequel une lumière polarisée circulairement et non parfaitement accordée à une transition atomique se comporte comme un champ magnétique fictif perturbant le comportement des atomes. Ces avantages rendent ces magnétomètres en alignement particulièrement intéressants pour l'imagerie des champs biomagnétiques au moyen d'un réseau de magnétomètres, notamment en magnétocardiographie ou en magnétoencéphalographie.

Dans un mode de réalisation alternatif, la lumière de pompage peut néanmoins être polarisée circulairement.

La deuxième unité 3 de la source optique est configurée pour éclairer ladite cellule 1 avec une lumière de sonde Ls polarisée linéairement qui va subir des variations de polarisation lors de la traversée de la cellule (rotation du plan de polarisation dans le cas d'un pompage des atomes en orientation au moyen d'une lumière de pompage polarisée circulairement, création d'une composante polarisée circulairement dans le cas d'un pompage des atomes en alignement au moyen d'une lumière de pompage polarisée linéairement).

La lumière de sonde Ls peut être émise par une source laser et être polarisée au moyen d'un polariseur 4 intercalé entre la source laser et la cellule ou directement intégré à la source laser 2.

La lumière de sonde Ls présente une fréquence accordée à la fréquence de résonance de la cellule optiquement résonante. La lumière de sonde Ls est incidente sur la cellule de manière à passer une pluralité de fois à travers ladite cellule en étant réfléchie par les miroirs.

Avec la configuration précédemment décrite, la lumière de pompage non-résonante peut être exactement accordée en longueur au centre de la raie atomique d'intérêt pour que l'efficacité du pompage soit maximale, tandis que la lumière de sonde résonante peut être décalée du centre de cette raie pour ne pas pomper également les atomes et permettre ainsi d'éviter la perte de signal due à l'absorption.

Le magnétomètre selon l'invention comporte par ailleurs un détecteur 5 qui reçoit la lumière de sonde ayant traversée la cellule et délivre un signal porteur d'une information relative à l'état (d'alignement ou d'orientation) des atomes du gaz atomique dans la cellule à une électronique de traitement 6 qui exploite ce signal pour fournir une mesure du champ magnétique ambiant Bo. Le détecteur 5 est plus particulièrement configuré pour réaliser une mesure polarimétrique de la lumière de sonde ayant traversée la cellule. Lorsque la lumière de pompage est polarisée linéairement, le détecteur est configuré pour détecter les composantes de polarisation circulaire. Lorsque la lumière de pompage est polarisée circulairement, le détecteur peut être configuré pour détecter les deux composantes à 45° et en déduire la rotation du plan de polarisation.

Prenant l'exemple d'un pompage en polarisation linéaire, le détecteur 5 est configuré pour séparer, spatialement ou temporellement, la polarisation circulaire droite et la polarisation circulaire gauche de la lumière de sonde ayant traversée la cellule.

Le détecteur peut ainsi comprend une lame quart d'onde 7, un cube séparateur 8 apte à séparer spatialement sur un premier et un deuxième chemin la polarisation circulaire droite et la polarisation circulaire gauche de la lumière de sonde ayant traversée la cellule et un photodétecteur 9, 10 sur chacun des premier et deuxième chemins. La différence entre les signaux photodétectés est fournie à l'électronique de traitement 6. Alternativement, le détecteur 5 peut ne comprendre qu'un seul photodétecteur. Dans cette réalisation alternative, il est nécessaire de sélectionner avant photodétection, de façon successive l'une puis l'autre des deux polarisations sur lesquelles le signal est analysé. Une telle séparation temporelle des deux polarisations peut être réalisée par exemple par un modulateur photo-élastique. Pour maintenir une bande passante significative dans la mesure magnétique, ce modulateur doit être excité à une fréquence suffisamment élevée, typiquement supérieure à quelques kHz. Cette réalisation peut s'avérer intéressante dans certaines applications en permettant de ne pas avoir à détecter simultanément deux faisceaux et donc de passer outre la difficulté à équilibrer les deux chemins. Par ailleurs elle présente également l'avantage de réduire l'impact que le bruit basse fréquence du laser peut avoir sur la mesure magnétique.

Dans un mode de réalisation possible, le magnétomètre est un magnétomètre basé sur la résonance paramétrique. Il comprend ainsi également un circuit d'excitation de résonances paramétriques qui comporte un générateur de radiofréquence qui alimente des bobines d'Helmholtz d'axes orthogonaux qui entourent la cellule afin de générer un champ magnétique d'excitation des résonances paramétriques, également désigné par champ radiofréquence d'excitation. Ce circuit d'excitation vient plus particulièrement générer un champ magnétique radiofréquence présentant deux composantes orthogonales à la direction de polarisation de la lumière de pompage et oscillant chacune à sa propre fréquence d'oscillation, à savoir une composante $B_{\omega}\cos\omega t$ oscillant à la pulsation $\omega$ et une composante $B_{\Omega}\cos\Omega t$ oscillant à la pulsation $\Omega$. Ces composantes conduisent à des résonances à chacune des fréquences d'oscillation $\Omega/2\pi$, $\omega/2\pi$ et à un inter-harmonique des fréquences d'oscillation $(\omega \pm \Omega)/2\pi$, ces résonances étant associées aux valeurs du champ ambiant selon les trois directions d'un trièdre rectangle.

Dans un autre mode de réalisation possible, le magnétomètre est un magnétomètre à double résonance du type de celui décrit par G. Di Domenico, H. Saudan, G. Bison, P. Knowles, et A. Weis dans « Sensitivity of double resonance alignment magnetometers », Phys. Rev. A76, 023407 (2007) qui exploite également un générateur de radiofréquence et un jeu de bobines d'Helmholtz pour appliquer un champ magnétique radiofréquence nécessaire pour induire la résonance magnétique.

Dans encore un autre mode de réalisation, le magnétomètre est un magnétomètre à effet Hanle qui lui ne nécessite pas un tel jeu de bobines.

Un magnétomètre selon l'invention peut également comprendre un système d'asservissement en boucle fermé du magnétomètre pour venir constamment soumettre la cellule à un champ magnétique total nul. Le système d'asservissement comprend un régulateur couplé à l'électronique de traitement qui injecte un courant dans des bobines de Helmholtz d'axes orthogonaux qui entourent la cellule afin de générer un champ magnétique de compensation Bc tel que la somme Bc+$B_0$ est maintenue à zéro en permanence. Alternativement, le magnétomètre peut être opéré en boucle ouverte, sans compensation du champ ambiant.

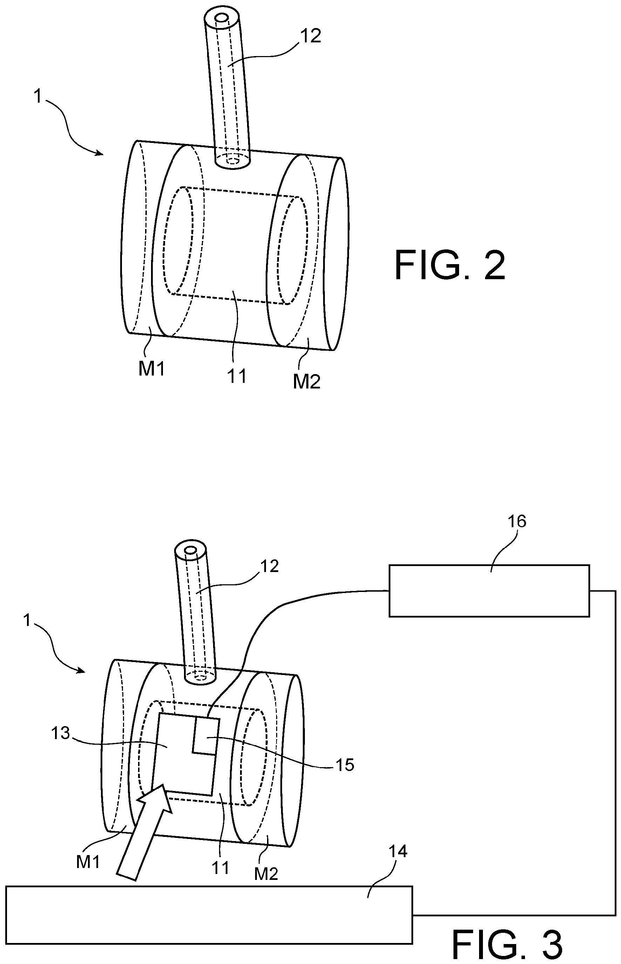

Un exemple de réalisation d'une cavité optiquement résonante pouvant être utilisée dans un magnétomètre selon l'invention est détaillée ci-dessous en référence à la figure 2. La cavité 1 comprend un conteneur 11 du gaz atomique et des miroirs M1, M2 agencés face-à-face de part et d'autre du conteneur. Le conteneur et les miroirs peuvent être assemblés par collage moléculaire. Le remplissage du conteneur s'effectue de manière conventionnelle à travers un conduit 12.

Le conteneur 11, réalisé en borosilicate, est de forme cylindrique. Il présente un diamètre interne de 10 mm, un diamètre externe de 18 mm et une longueur de 10 mm le long d'un axe optique de la cellule. Il définit un volume d'environ 0,8 cm$^3$ d'hélium-4. Le parallélisme entre ses faces orthogonales à l'axe optique est assuré à une seconde d'arc près.

Le conduit 12 a une longueur de 50 mm. Il présente un diamètre externe de 4 mm et un diamètre interne de 1,5 mm. Il est rapporté au milieu de la cavité, perpendiculairement à l'axe optique.

Les miroirs M1, M2 sont en borosilicate. Ils présentent un diamètre de 18mm et une épaisseur de 6 mm. Leurs faces en vis-à-vis ne sont pas parallèles mais font entre elles un angle de 30 minutes d'arc. La face interne de chaque miroir (côté conteneur) porte un revêtement réflecteur présentant une réflectivité de 90% à 1080 nm. Sa planéité est inférieure à $\lambda$/25. La face externe de chaque miroir porte un revêtement anti-réflecteur. Sa planéité est inférieure à $\lambda$/4.

En référence à la figure 3, un magnétomètre selon l'invention comprend avantageusement un système d'accord pour accorder la fréquence de résonance de la cellule 1 à la fréquence de la lumière de sonde Ls Ce système d'accord peut comprendre un dispositif de chauffage de ladite cellule. Ce dispositif de chauffage peut comprendre au moins un absorbeur de chaleur 13 placé sur la cellule, par exemple sous la forme d'un film noir métallique, et une source de chaleur configurée pour irradier l'absorbeur de chaleur, par exemple un laser à fibre opérant dans l'infrarouge. On prévoit de préférence deux absorbeurs de chaleur de part et d'autre de la cellule. Ces absorbeurs peuvent avantageusement servir d'électrodes pour appliquer la décharge haute fréquence aux atomes du gaz atomique.

Un thermomètre 15 accolé à ladite cellule permet d'en mesurer la température. Le thermomètre 15 est couplé à un contrôleur 16 configuré pour contrôler le dispositif de chauffage à partir de la température mesurée. La température de la cellule peut ainsi être contrôlée avec une précision de 0,01°C.

Un modèle mathématique complet d'un magnétomètre selon l'invention, à résonance paramétrique et pompé en alignement, a été développé qui comprend :

- le calcul de l'évolution de l'état atomique sous le champ radiofréquence $B_\omega \cos\omega t$ et le champ quasi-statique $B_0$ que l'on cherche à mesurer. Les effets du pompage optique en alignement et de la dépopulation due au pompage optique sont pris en considération ;
- le calcul du rapport signal-à-bruit en prenant en considération l'évolution de la polarisation de la lumière de sonde à l'intérieur de la cellule.

Une longueur d'onde optimale de la lumière de sonde qui permet de maximiser le rapport signal-à-bruit S.N.R peut être déterminée à partir de l'équation suivante lorsque $\Gamma$pump≈$\Gamma$nat :

$$S.N.R = \frac{\sqrt{h\,v}}{\sqrt{2\,I_0}\,\gamma\,J_{0,2}\,J_{1,2}} \left\{ \frac{(R-3)(R-1)\,\Gamma_{nat}}{\Delta E(\lambda)} - \right.$$

$$\frac{\left(-49+313\,R+36\,J_{0,2}{}^2 J_{1,2}{}^2(1+7\,R)\right)\,\Gamma_{nat}\,\Delta E(\lambda)}{288\,(R-1)} + \Gamma(\lambda)$$

$$\left. \left( \frac{(13+7\,R)\,\Gamma_{nat}}{12\,\Delta E(\lambda)} + \frac{\left(-361+36\,J_{0,2}{}^2 J_{1,2}{}^2(17-39\,R)+591\,R\right)\,\Gamma_{nat}\,\Delta E(\lambda)}{864\,(R-1)^2} \right) \right\}$$

où h est la constant de Planck, v la fréquence de la lumière de sonde, $I_0$ l'intensité de la lumière de sonde, R la réflectivité (intensité) des miroirs de la cellule, $\gamma$ le rapport gyromagnétique, $J_{n,s}=J_n(s\gamma B_1/\omega)$ avec $J_n$ la fonction de Bessel de première espèce, $\Gamma_{nat}$ le taux de désexcitation correspondant à la largeur de la raie atomique, $\Gamma_{pump}$ le taux de désexcitation correspondant à l'effet de la lumière de pompage, $\Gamma(\lambda)=3\pi r_e cNIfRe[V(\lambda)]$ et $\Delta E(\lambda)={}^3/_2\pi r_e cNIfIm[V(\lambda)]$ sont respectivement l'élargissement et le déplacement de l'état atomique dues à l'excitation optique, laquelle dépend de la longueur d'onde de la lumière de pompage à travers le profil de résonance de Voigt

$$V(\lambda) = \frac{2\sqrt{Log(2)/\pi}}{\Gamma_d} W\left[\frac{2c\sqrt{Log(2)/\pi}(1/\lambda - 1/\lambda_r + i\Gamma_n/2)}{\Gamma_d}\right]$$

. La fonction Faddeeva est définie selon $W[x]=e^{-x^2}(1-Erf[-i\,x])$. Ici $r_e$ est le rayon classique de l'électron, c la vitesse de la lumière dans le vide, N la densité du gaz atomique, I the longueur de la cellule, f la force d'oscillateur de la transition atomique, $\Gamma_d$ la largeur Doppler de la raie and $\Gamma_n$ the largeur de raie naturelle.

On considère les paramètres habituels suivants d'une cellule remplie d'helium-4 (20 Torr) fonctionnant sur la transition D0 et avec une réflectivité R = 0.9.

| | |
|---|---|
| $\gamma$ | 28 Hz/nT |
| $\Gamma_{nat}$ | $10^3$ s$^{-1}$ |
| N | $10^{17}$ 1/m$^3$ |
| I | 0.01 m |
| f | 0.06 |
| $\lambda_r$ | 1083.205 nm |
| $\Gamma_d$ | $1.7 \times 10^9$ s$^{-1}$ |
| $\Gamma_n$ | $2 \times 10^6$ s$^{-1}$ |

La longueur d'onde optimale de la lumière de sonde est 1083,211±0,002 nm conduisant à un rapport signal-à-bruit, considérant que le magnétomètre est affecté d'un bruit de photons, qui est approximativement de 0.8 $fT/\sqrt{Hz}$.

## Revendications

1. Magnétomètre à pompage optique, comprenant :

une cellule optiquement résonante (1) remplie d'un gaz atomique, ladite cellule présentant une fréquence de résonance ;
une source optique (2, 3) configurée pour éclairer ladite cellule avec :

une lumière de pompage (Lp) sous l'effet de laquelle les atomes du gaz atomique subissent une transition atomique, la lumière de pompage ayant une première fréquence non accordée à la fréquence de résonance ;

et

une lumière de sonde (Ls) qui subit des variations de polarisation lors de la traversée de la cellule, la lumière de sonde ayant une fréquence accordée à la fréquence de résonance et passant une pluralité de fois à travers ladite cellule ;

un détecteur (5) configuré pour réaliser une mesure polarimétrique de la lumière de sonde ayant traversée la cellule.

2. Magnétomètre à pompage optique selon la revendication 1, dans lequel ladite cellule comprend des miroirs (M1, M2) agencés face-à-face et un conteneur (11) du gaz atomique entre les miroirs.

3. Magnétomètre à pompage optique selon l'une des revendications 1 et 2, comprenant en outre un système d'accord (13, 14, 15, 16) pour accorder la fréquence de résonance à la fréquence de la lumière de sonde.

4. Magnétomètre à pompage optique selon la revendication 3, dans lequel le système d'accord comprend un dispositif de chauffage (13, 14) de ladite cellule.

5. Magnétomètre à pompage optique selon la revendication 4, dans lequel le dispositif de chauffage comprend un absorbeur de chaleur (13) placé sur la cellule et une source de chaleur (14) configurée pour irradier l'absorbeur de chaleur.

6. Magnétomètre à pompage optique selon l'une des revendications 4 et 5, dans lequel le système d'accord comprend en outre un thermomètre (15) couplé à ladite cellule pour en mesurer la température et un contrôleur (16) configuré pour contrôler le dispositif de chauffage (13, 14) à partir de la température mesurée.

7. Magnétomètre à pompage optique selon l'une des revendications 1 à 6, dans lequel la lumière de pompage (Lp) est accordée en longueur d'onde au centre d'une raie atomique et la lumière de sonde (Ls) est accordée en longueur d'onde de manière à être décalée du centre de ladite raie atomique.

8. Magnétomètre à pompage optique selon l'une des revendications 1 à 7, dans lequel le détecteur comprend un analyseur de polarisation (7, 8, 9, 10) configuré pour séparer, spatialement ou temporellement, la polarisation circulaire droite et la polarisation circulaire gauche de la lumière de sonde ayant traversée la cellule.

9. Magnétomètre selon la revendication 8, dans lequel l'analyseur de polarisation est configuré pour réaliser une mesure différentielle desdites polarisations droite et gauche.

10. Magnétomètre selon l'une des revendications 1 à 9, comprenant en outre un circuit d'excitation de résonances paramétriques configuré de manière à induire dans la cellule une modulation de champ radiofréquence.

11. Magnétomètre selon l'une des revendications 1 à 10, dans lequel la lumière de pompage est polarisée linéairement.


**Patentansprüche**

1. Optisch gepumptes Magnetometer, umfassend:

eine optisch resonante Zelle (1), die mit einem atomaren Gas gefüllt ist, wobei die Zelle eine Resonanzfrequenz aufweist;
eine optische Quelle (2, 3), die dazu ausgebildet ist, die Zelle zu beleuchten, mit:

einem Pumplicht (Lp), unter dessen Wirkung die Atome des Atomgases einen atomaren Übergang durchlaufen, wobei das Pumplicht eine erste Frequenz aufweist, die nicht auf die Resonanzfrequenz abgestimmt ist; und
ein Sondenlicht (Ls), das beim Durchlaufen der Zelle Polarisationsveränderungen erfährt, wobei das Sondenlicht eine auf die Resonanzfrequenz abgestimmte Frequenz aufweist und die Zelle mehrmals durchläuft;
einen Detektor (5), der dazu ausgebildet ist, eine polarimetrische Messung des Sondenlichts, das die Zelle durchlaufen hat, durchzuführen.

2. Optisch gepumptes Magnetometer nach Anspruch 1, wobei die Zelle Spiegel (M1, M2) umfasst, die einander zugewandt angeordnet sind, und einen Behälter (11) des atomaren Gases zwischen den Spiegeln umfasst.

**3.** Optisch gepumptes Magnetometer nach einem der Ansprüche 1 und 2, welches ferner ein Abstimmsystem (13, 14, 15, 16) zum Abstimmen der Resonanzfrequenz auf die Frequenz des Sondenlichts umfasst.

**4.** Optisch gepumptes Magnetometer nach Anspruch 3, wobei das Abstimmsystem eine Heizvorrichtung (13, 14) für die Zelle umfasst.

**5.** Optisch gepumptes Magnetometer nach Anspruch 4, wobei die Heizvorrichtung einen auf der Zelle platzierten Wärmeabsorber (13) und eine Wärmequelle (14) umfasst, die dazu ausgebildet ist, den Wärmeabsorber zu bestrahlen.

**6.** Optisch gepumptes Magnetometer nach einem der Ansprüche 4 oder 5, wobei das Abstimmsystem weiterhin ein Thermometer (15) umfasst, das mit der Zelle gekoppelt ist, um deren Temperatur zu messen, und einen Regler (16) umfasst, der dazu ausgebildet ist, die Heizvorrichtung (13, 14) auf der Grundlage der gemessenen Temperatur zu steuern.

**7.** Optisch gepumptes Magnetometer nach einem der Ansprüche 1 bis 6, wobei das Pumplicht (Lp) in der Wellenlänge auf das Zentrum einer Atomlinie abgestimmt ist und das Sondenlicht (Ls) in der Wellenlänge so abgestimmt ist, dass es vom Zentrum der Atomlinie versetzt ist.

**8.** Optisch gepumptes Magnetometer nach einem der Ansprüche 1 bis 7, wobei der Detektor einen Polarisationsanalysator (7, 8, 9, 10) umfasst, der dazu ausgebildet ist, die rechtszirkuläre Polarisation und die linkszirkuläre Polarisation des Sondenlichts, das die Zelle durchlaufen hat, räumlich oder zeitlich voneinander zu trennen.

**9.** Magnetometer nach Anspruch 8, wobei der Polarisationsanalysator dazu ausgebildet ist, eine differentielle Messung der rechten und linken Polarisation durchzuführen.

**10.** Magnetometer nach einem der Ansprüche 1 bis 9, welches ferner eine Anregungsschaltung für parametrische Resonanzen umfasst, die dazu ausgebildet ist, in der Zelle eine Radiofrequenzfeldmodulation zu induzieren.

**11.** Magnetometer nach einem der Ansprüche 1 bis 10, wobei das Pumplicht linear polarisiert ist.

## Claims

**1.** An optically pumped magnetometer, comprising:

an optically resonant cell (1) filled with an atomic gas, said cell having a resonance frequency;
an optical source (2, 3) configured to illuminate said cell with:

a pumping light (Lp) under the effect of which atoms of the atomic gas undergo an atomic transition, the pumping light having a first frequency that is not tuned to the resonance frequency; and
a probe light (Ls) that undergoes polarization variations when it passes through the cell, the probe light having a frequency that is tuned to the resonance frequency and passing through said cell multiple times;

a detector (5) configured to make a polarimetric measurement of the probe light having passed through the cell.

**2.** The optically pumped magnetometer according to claim 1, wherein said cell comprises mirrors (M1, M2) arranged face-to-face and a container of the atomic gas between the mirrors.

**3.** The optically pumped magnetometer according to claim 1 or 2, further comprising a tuning system (13, 14, 15, 16) for tuning the resonance frequency to the frequency of the probe light.

**4.** The optically pumped magnetometer according to claim 3, wherein the tuning system comprises a heating device (13, 14) for heating said cell.

**5.** The optically pumped magnetometer according to claim 4, wherein the heating device comprises a heat absorber (13) placed on the cell and a heat source (14) configured to irradiate the heat absorber.

6.  The optically pumped magnetometer according to claim 4 or 5, wherein the tuning system further comprises a thermometer (15) coupled to said cell to measure the temperature thereof and a controller (16) configured to control the heating device (13, 14) from the measured temperature.

7.  The optically pumped magnetometer according to any of claims 1 to 6, wherein the pumping light (Lp) is tuned in terms of wavelength to a center of an atomic ray and the probe light (Ls) is tuned in terms of wavelength so as to be offset from the center of said atomic ray.

8.  The optically pumped magnetometer according to any of claims 1 to 7, wherein the detector comprises a polarization analyzer (7, 8, 9, 10) configured to separate, spatially or temporally, a right circular polarization and a left circular polarization of the probe light having passed through the cell.

9.  The magnetometer according to claim 8, wherein the polarization analyzer is configured to take a differential measurement of said right and left polarizations.

10. The optically pumped magnetometer according to any of claims 1 to 9, further comprising a parametric resonance excitation circuit configured so as to induce a radiofrequency field modulation in the cell.

11. The optically pumped magnetometer according to any of claims 1 to 10, wherein the pumping light is linearly polarized.

FIG. 1

EP 3 771 917 B1

FIG. 2

FIG. 3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5982174 A

**Littérature non-brevet citée dans la description**

- **S. LI et al.** Optical rotation in excess of 100 rad generated by Rb vapor in a multipass cell. *Phys. Rev. A,* 2011, vol. 84, 061403
- **H.CREPAZ ; LI YUAN LEY ; R. DUMKE.** Cavity enhanced atomic magnetometry. *Sci. Rep.,* 2015, vol. 5, 15448
- **F. BEATO et al.** Theory of a He parametric-resonance magnetometer based on atomic alignment. *Physical Review A,* 2018, vol. 98, 053431
- **G. DI DOMENICO ; H. SAUDAN ; G. BISON ; P. KNOWLES ; A. WEIS.** Sensitivity of double resonance alignment magnetometers. *Phys. Rev. A,* 2007, vol. 76, 023407